(19) Europäisches Patentamt

European Patent Office

Office européen des brevets

(11) EP 0 746 183 B1

(12) **EUROPEAN PATENT SPECIFICATION**

(45) Date of publication and mention
of the grant of the patent:
**06.11.2002 Bulletin 2002/45**

(51) Int Cl.⁷: **H05B 37/03**, G01R 21/06,
G01R 21/133

(21) Application number: **95830231.7**

(22) Date of filing: **31.05.1995**

(54) **An electronic device for accurate identification at distance of malfunctions in lamps**

Elektronische Vorrichtung zur Fernerkennung von Funktionsstörungen in Lampen

Appareil électronique pour détecter à distance du fontionnement défectueux des lampes

(84) Designated Contracting States:
**AT BE CH DE DK ES FR GB IT LI LU MC NL PT SE**

(43) Date of publication of application:
**04.12.1996 Bulletin 1996/49**

(73) Proprietor: **UMPI ELETTRONICA S.R.L.**
**47033 Cattolica (IT)**

(72) Inventors:
• **Cecchini, Piero**
  **I-47033 Cattolica (RN) (IT)**
• **Grossi, Alberto**
  **I-47037 Rimini (RN) (IT)**

(74) Representative: **Lanzoni, Luciano**
**c/o BUGNION S.p.A.**
**Via Cairoli, 107**
**47900 Rimini (Forli) (IT)**

(56) References cited:
**EP-A- 0 432 386**     **EP-A- 0 501 887**
**EP-A- 0 576 098**     **EP-A- 0 586 322**
**EP-A- 0 637 195**     **DE-A- 3 126 485**
**US-A- 4 979 122**

• **PATENT ABSTRACTS OF JAPAN vol. 13 no. 239**
**(P-879) ,6 June 1989 & JP-A-01 043766 (HIOKI**
**DENKI K.K.) 16 February 1989,**

## Description

The invention relates to an electronic device for accurate identification at distance of malfunctions in lamps, comprising monitoring means of the current and voltage connected to a microprocessor unit.

In both public and private sectors, or indeed wherever illumination is provided by a series of lamps, distance control of the illumination network is needed so that whenever a lamp fails it can swiftly be restored to full functionability.

This need obviously arises in situations where vast areas have to be managed and perfect efficiency is particularly required.

As the majority of lamps used in public spaces are constituted by discharge lamps, and since the elements constituting these lamps are as follows: reactor, lighter, bulbs with power factor correction condenser, one of the essential aspects of the problem is the ability to verify if a malfunction of the lamp is due to one of the above-mentioned elements.

The applicant's previous European patent publication no. 0.637.195 related to the functional state of the lamp by means of a calculation of the power correction factor between voltage and current such that different reasons for failure caused different values in the phase angle, each of which values could therefore be ascribed to a particular reason for failure.

Apart from the applicant's invention, other like-minded patents or realizations utilized passage through zero of the voltage and current to determine the power correction factor: measurement of the time of passage through zero of the voltage and that for the current enabled a calculation to be made of the phase angle, and thus of the state of the lamp.

All the realizations based on the above concept refer to an ideal sine curve, while in reality the curve is always distorted, both with respect to the supply voltage and the current absorbed by the lamp and due to the presence of non-linear electric charges of a different nature for the charge, all of which lead to a series of imprecisions and errors in the determination of the passage through zero of the current and the voltage and thus of the identification of the state of the lamp, since there might be small passages due to small distortions related to secondary harmonics.

In particular the lamp generally does not behave linearly at variation of voltage supply and the power correction factor condenser, being dimensioned at the necessary limit value calculated by its normal functioning conditions and thus equipped with a new lamp, influences the difference in the phase angle between normal state and condenser off, which is the opposite critical position.

Finally, the phase angle method does not allow identification of whether the poor functioning of the lamp is due to a defect in the lighter or another component of the discharge lamp.

Thus all of the above-described solutions and limitations, although based on a common criterion, give no effective guarantee of phase displacement and thus are not fully objective in malfunction identification.

To sum up, the realizations proposed up to date utilize the technique of the calculation of the phase angle, but cannot be considered extremely reliable due to the imperfect linearity of the voltage and the current wave.

To solve the above problems reference has been made to a device which calculates, the apparent power and active power absorbed by a lamp, on the basis of instant measurements of voltage and current, and thus measurements taking into account harmonic and disturbance factors; such measurements are thus immune from any transitory passages through zero of the current and voltage curves; all of which is obviously processed by means of an appropriately set microprocessor.

The present invention, as it is set out in the following claims, has the aim of obviating the above-mentioned drawbacks in devices in present use by providing a device into which a microprocessor system has been integrated, which device solves said technical problems.

This aim and others besides, which will better emerge in the following description, are all achieved by the device of the present invention.

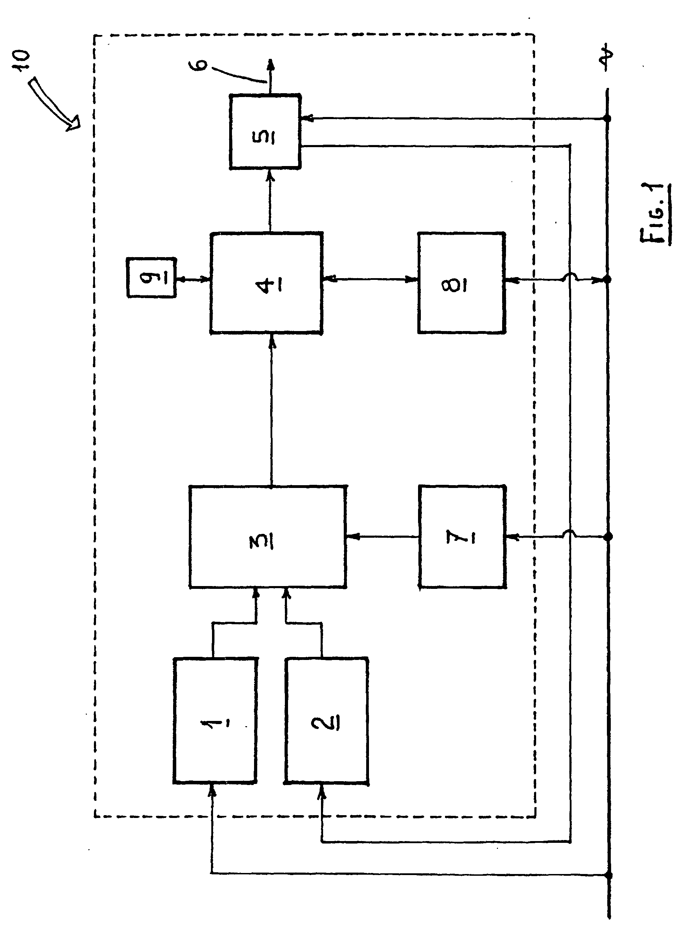

Further characteristics and advantages of the present invention will better emerge from the detailed description that follows, of a preferred but non-exclusive embodiment of an electronic device for accurate identification at distance of malfunctions in lamps for illumination here illustrated in the form of a non-limiting example in the accompanying figure 1 of the drawing, which sets out a block diagram of the whole device, showing the essential elements thereof.

In the figure of the drawing, 10 denotes a device according to the present invention, which is located in each lamp to be distance-controlled, by means of a command and control panel, not illustrated in the figure.

The device comprises, within a broken line representing its whole, a series of circuit blocks all having a specific aim.

Block 1 indicates a voltage analogic signal amplifier, reading the signals at the lamp extremities.

Block 2 indicates a like amplifier of analogic current signals.

Both of the above amplifiers 1 and 2 are connected up to a 220V alternated supply line from which they each take their parameters.

Said amplifiers send their respective signals to an analogic-digital converter 3, which transmits the necessary instant value of voltage current in the form of a sample.

A microprocessor 4, provided with its own memory 9 containing tables of lamp correct function parameters, that is the functional states of the lamps, processes said instant values and calculates real parameters, comparing same with the tabulated values, taking account of the samples generated.

These tables are loaded in an EEprom memory 9 contained in the microprocessor 4.

The device further exhibits in output a lamp command switch 5 for extinguishing said lamp, which can be distance controlled from the central panel, or locally controlled by the microprocessor 4 in cases where the lamp is defective but the lighter (a characteristic of discharge lamps) remains on, since it might generate undesirable disturbances of an electromagnetic nature interfering with outside concerns, such as airports, radio receivers and so on.

Figure 1 also shows a block 7 identifying the device supplier, as well as a block 8 indicating a power line currier transreceiver, to which each device 10 is connected along a public illumination line constituted by the lamps, and intended to distance-manage same.

Following the purely structural description proposed above, there now follows a functional explanation.

As the first calculations are of the active and apparent powers absorbed by a lamp with the aim of avoiding the supply difficulties caused by secondary harmonics and voltage and current wave distortion, passage through zero of both voltage and current can be avoided in the following way.

Once the values of apparent power and active power values at the extremities of the lamps have been identified, by means of amplifiers 1 and 2, the analogic-digital converter 3 provides in output a digital signal both of the voltage and the above-mentioned current, with a sample frequency which is sufficient to guarantee a precise digital correspondence to the analogic signals of the abovementioned current and voltage.

At this point the microprocessor calculates the effective value of the voltage (Veff) and the current (Ieff), for the subsequent calculation of the active power (P) and the apparent power (S), according to the following electrotechnical mathematical formulae:

$$Veff := \sqrt{1/2\pi n \cdot \int_0^{2\pi n} Vi^2 \, dt}; \quad Ieff. = \sqrt{1/2\pi n \cdot \int_0^{2\pi n} Ii^2 \, dt}$$

$$P = 1/2\pi n \cdot \int_0^{2\pi n} (Vi \cdot Ii) \, dt \quad S = Veff \cdot Ieff.$$

where Vi and Ii are the instant values of the voltage and the current and where n is the number of cycles (frequency).

In this way the calculation takes account of any disturbance and distortion in the waves or sine curves which represent the voltage and current at the extremities of the lamp.

The microprocessor 4 calculates the value of the effective voltage and the effective current on the basis of the digital instant values it receives through the analogic-digital converter 3 and according to the above-expressed formulae, where the instant values are provided by the analogic-digital converter 3 and where the mathematical integration operation is calculated equivalently through a sum of values in a mathematically sufficient number of discrete values. For each calculation of the active and apparent power, it also compares said values with corresponding lists of values tabulated in the reference memory 9, where each value corresponds to a good lamp functionability.

The microprocessor 4 also calculates the rapport between the active and apparent powers, deriving thus a phase angle and comparing, time by time, said values of the phase angle, which take into account any disturbances or harmonics of the analogic input voltage and current signals with tabulated values specifically referring to phase angles of correct lamp functionability.

As the supply frequency is 50 Hz and the harmonics are not significant after the fifteenth/twentieth, a reliable sampling about 40 values per period can be obtained, in order to calculate sufficiently precisely the effective and instant values of the voltage and the current. Thus the supply voltage effective value is obtained and can be compared with the memory 9 tables with the instant values of the apparent power and the active power when the voltage is varied, in order to identify with greater precision the state of the lamp and therefore the phase angle.

The measurement of the harmonics on the voltage and the current permit verification of whether the lighter is active and therefore functional.

In normal conditions, with the lamp off, the lighter generate peaks of voltage, generally one for each single period of a few kilo-volts, necessary to prime the lighter; these peaks lead to the presence of easily recognisable harmonics.

If the lamp is off, therefore, it is possible to verify whether the lighter is functioning and thus if it is the reason for an eventual malfunction of the lamp.

Thus the invention achieves its set aims. It is possible to verify the current phase angle independently of the distortions due to various causes and thus identify more reliably and exactly first whether a lamp is actually functioning or not and secondly the cause of a failure.

Obviously further parameter and circuit variations are possible, all entering into the scope of the invention.

**Claims**

1. An electronic device for accurate identification at distance of malfunctions in lamps, comprising a power line carrier device, monitoring means of digital values of function parameters of each lamp and a microprocessor which compares said values with other predetermined lists of values stored in a memory of the microprocessor, where each value corresponds to a good lamp functionability, **characterized in that** said monitoring means comprise at least a circuit for analogic monitoring of a voltage and current at extremities of each said lamp and a means for sampling, situated downstream of said at least a circuit for analogic monitoring, for providing in output a digital signal both of said voltage and of said current, with a sampling frequency which is sufficient to guarantee a precise digital correspondence to analogic signals relating to said voltage and current, said microprocessor (4) calculating a value of effective voltage and effective current on a basis of instant digital values received thereby through said means for sampling, such as to be able to calculate active power and apparent power of said instant digital values and to compare same with values tabulated in a reference memory (9), in which memory (9) each value corresponds to a good functionability of the lamp, said microprocessor (4) permitting of verifying, through a measurement of harmonics on the voltage and the current received by said circuits for analogic monitoring of a voltage and current and by said means for sampling, whether a lighter provided on each said lamp for igniting same is active and therefore functioning.

2. A device as in claim 1, **characterized in that** said microprocessor (4) further calculates a rapport between said active power and said apparent power, deriving thus a phase angle and comparing, time by time, said values of the phase angle, which take into account any disturbances or harmonics of the analogic input voltage and current signals with tabulated values contained in said memory (9) specifically referring to phase angles of correct lamp functionability.

3. A device as in claim 1, **characterized in that** said analogic monitoring circuits are amplifiers (1, 2).

4. A device as in claim 1, **characterized in that** said means for sampling is an analogic-digital converter (3), activated at prefixed times by the microprocessor (4).

5. A device as in claim 1, **characterized in that** it comprises, in combination, a block (8) denoting a power line carrier transreceiver to which each device (10) is connected along a public illumination line constituted by a series of the lamps, for the distance monitoring thereof.

6. A device as in claim 1, **characterized in that** said device (10) comprising in output a lamp command switch (5).

**Patentansprüche**

1. Elektronische Vorrichtung zur Fernerkennung von Funktionsstörungen in Lampen, enthaltend eine Vorrichtung zur Trägerfrequenzübertragung, Erfassungsmittel der Digitalwerte von Funktionsparametern einer jeden Lampe und einen Mikroprozessor, welcher die genannten Werte mit anderen, vorgegebenen Werteverzeichnissen vergleicht, welche in einem Speicher des Mikroprozessors gespeichert sind, wo jeder Wert der guten Funktionstüchtigkeit einer Lampe entspricht, **dadurch gekennzeichnet, dass** die genannten Erfassungsmittel wenigstens einen Kreis zum analogischen Erfassen von Spannung und Strom an den Enden einer jeden Lampe enthalten sowie ein Mittel zum Bemustern, angeordnet stromabwärts des genannten, wenigstens einen Kreises, zum analogischen Erfassen, um am Ausgang ein digitales Signal der genannten Spannung wie auch des genannten Stromes zu erzeugen, und zwar mit einer Bemusterungsfrequenz, welche ausreichend ist, um eine genaue digitale Übereinstimmung mit den analogischen Signalen zu gewährleisten, die sich auf die genannte Spannung und den Strom beziehen, wobei der genannte Mikroprozessor (4) einen Wert der effektiven Spannung und des effektiven Stromes errechnet, und zwar auf der Basis der im gleichen Augenblick durch das genannte Bemusterungsmittel empfangenen digitalen Werte, so dass er in der Lage ist, die aktive Leistung und die Scheinleistung der genannten augenblicklichen Werte zu berechnen und diese mit den in einem Bezugsspeicher (9) verzeichneten Werten zu vergleichen, in welchem Bezugsspeicher (9) jeder Wert einer guten Funktiontüchtigkeit der Lampe entspricht, wobei der genannte Mikroprozessor (4) durch die Messung der Harmonischen an der Spannung und an dem Strom, empfangen von den genannten Kreisen zum analogischen Erfassen von Spannung und Strom und von den genannten Bemusterungsmitteln, es erlaubt zu prüfen, ob ein an einer jeden genannten Lampe vorgesehener Zünder zum Zünden derselben aktiv ist und somit funktioniert.

**2.** Vorrichtung nach Patentanspruch 1, **dadurch gekennzeichnet, dass** der genännte Mikroprozessor (4) ausserdem das Verhältnis zwischen der genannten aktiven Leistung und der genannten Scheinleistung berechnet, woraus er einen Phasenwinkel ableitet und die genannten Werte der Phasenwinkel, welche jegliche Störungen oder Harmonische der analogischen Eingangsspannung und der Stromsignale berücksichtigen, von Mal zu Mal mit den aufgezeichneten Werten vergleicht, die in dem genannten Speicher (9) enthalten sind, die sich insbesondere auf Phasenwinkel der einwandfreien Funktion der Lampen beziehen.

**3.** Vorrichtung nach Patentanspruch 1, **dadurch gekennzeichnet, dass** die genannten analogischen Kreise zum Erfassen Verstärker (1, 2) sind.

**4.** Vorrichtung nach Patentanspruch 1, **dadurch gekennzeichnet, dass** die genannten Mittel zur Bemusterung ein analog-digitaler Umwandler (3) ist, der zu festgelegten Zeiten von dem Mikroprozessor (4) aktiviert wird.

**5.** Vorrichtung nach Patentanspruch 1, **dadurch gekennzeichnet, dass** sie in Kombination einen Block (8) enthält, der einen Trägerfrequenzübertrager beschreibt, an welchen jede Vorrichtung (10) entlang einer öffentlichen Beleuchtungsanlage angeschlossen ist, die aus einer Reihe von Lampen besteht, und zwar zur Fernüberwachung derselben.

**6.** Vorrichtung nach Patentanspruch 1, **dadurch gekennzeichnet, dass** die genannte Vorrichtung (10) am Ausgang einen Schalter (5) zur Betätigung der Lampe enthält.

**Revendications**

**1.** Un appareil électronique pour la détection à distance du fonctionnement défectueux des lampes, comprenant un dispositif porteur sur ligne d'alimentation, des moyens de contrôle de valeurs digitales des paramètres fonctionnels de chaque lampe, et un microprocesseur comparant lesdites valeurs avec d'autres listes prédéterminées de valeurs emmagasinées dans une mémoire du microprocesseur, dans laquelle chaque valeur correspond à un bon fonctionnement de la lampe, **caractérisé en ce que** lesdits moyens de contrôle comprennent au moins un circuit de contrôle analogique de la tension et de l'intensité aux extrémités de chaque lampe et des moyens d'échantillonnage, situés en aval dudit circuit de contrôle analogique, pour fournir en sortie un signal digital de ladite tension et de ladite intensité, avec une fréquence d'échantillonnage suffisante pour garantir une correspondance digitale précise aux signaux analogiques relatifs auxdites tension et intensité, ledit microprocesseur (4) calculant une valeur de la tension effective et de l'intensité effective sur la base de valeurs digitales instantanées qui lui parviennent par l'intermédiaire desdits moyens d'échantillonnage, de manière à pouvoir calculer la puissance active et la puissance apparente desdites valeurs digitales instantanées et à les comparer avec des valeurs classées dans une mémoire de référence (9), dans laquelle chaque valeur correspond à un bon fonctionnement de la lampe, ledit microprocesseur (4) permettant de vérifier, par l'intermédiaire de la mesure des harmoniques sur la tension et l'intensité reçues par lesdits circuits de contrôle analogique de la tension et de l'intensité et par lesdits moyens d'échantillonnage, si l'amorceur monté sur chaque lampe pour l'allumer est actif et donc fonctionnant.

**2.** Un appareil selon la revendication 1, **caractérisé en ce que** ledit microprocesseur (4) calcule de plus le rapport entre ladite puissance active et ladite puissance apparente, en en extrapolant l'angle de déphasage et comparant, chaque fois, lesdites valeurs de l'angle de déphasage, qui tiennent compte des perturbations ou harmoniques des signaux analogiques de tension et d'intensité en entrée, avec les valeurs classées contenues dans ladite mémoire (9) en se référant spécifiquement aux angles de déphasage d'un fonctionnement correct de la lampe.

**3.** Un appareil selon la revendication 1, **caractérisé en ce que** lesdits circuits de contrôle analogique sont des amplificateurs (1, 2).

**4.** Un appareil selon la revendication 1, **caractérisé en ce que** lesdits moyens d'échantillonnage sont un convertisseur analogique-digital (3), activé en des temps prédéterminés par le microprocesseur (4).

**5.** Un appareil selon la revendication 1, **caractérisé en ce qu'**il comprend, en combinaison, un bloc (8) désignant un récepteur-émetteur porteur sur ligne d'alimentation auquel chaque dispositif (10) est relié le long d'une ligne d'illumination publique constituée d'une série de lampes pour leur contrôle à distance.

**6.** Un appareil selon la revendication 1, **caractérisé en ce que** ledit dispositif (10) comprend en sortie un interrupteur de commande (5) de la lampe.

Fɪɢ. 1